(19) Europäisches Patentamt
European Patent Office
Office européen des brevets

(11) **EP 3 385 669 A1**

(12) **EUROPEAN PATENT APPLICATION**

(43) Date of publication:
**10.10.2018 Bulletin 2018/41**

(51) Int Cl.:
**G01C 19/5776** *(2012.01)*

(21) Application number: **18163590.5**

(22) Date of filing: **23.03.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.03.2017 JP 2017060383**

(71) Applicant: **Seiko Epson Corporation**
**Tokyo 160-8801 (JP)**

(72) Inventors:
• **Naoki, II**
**Nagano, 392-8502 (JP)**
• **MURASHIMA, Noriyuki**
**Nagano, 392-8502 (JP)**

(74) Representative: **Hoffmann Eitle**
**Patent- und Rechtsanwälte PartmbB**
**Arabellastraße 30**
**81925 München (DE)**

(54) **CIRCUIT DEVICE, PHYSICAL QUANTITY MEASUREMENT DEVICE, ELECTRONIC DEVICE, AND VEHICLE**

(57)     A circuit device includes a drive circuit configured to drive a physical quantity transducer by a drive signal, a PLL circuit configured to generate a clock signal by using a drive signal as a reference signal, and a measurement circuit that includes a circuit which is operated by an operation signal based on the clock signal and performs measurement processing based on a measurement signal from the physical quantity transducer, and the PLL circuit generates the clock signal having a frequency of $j \times fdr \neq fck/i$ in a case where it is set that a frequency of the drive signal is fdr, a frequency of the clock signal is fck, i is an integer of 1 or more, j is an integer of 1 or more, and a frequency of the operation signal is fck/i.

FIG. 1

**Description**

BACKGROUND

1. Technical Field

The present invention relates to a circuit device, a physical quantity measurement device, an electronic device, a vehicle, and the like.

2. Related Art

In the related art, a circuit device that measures a physical quantity based on a measurement signal from a physical quantity transducer is known. When a gyro sensor is taken as an example, the circuit device measures an angular velocity or the like as the physical quantity. The gyro sensor is incorporated in an electronic device such as a digital camera, a smartphone, or the like, a vehicle such as an automobile, an airplane, or the like, and performs camera shake correction, attitude control, GPS autonomous navigation, and the like using the physical quantity such as the measured angular velocity.

In JP-A-2016-133469, a method of adjusting an oscillation frequency so that a drive frequency of a drive circuit driving the physical quantity transducer does not interfere with an oscillation frequency of a built-in oscillation circuit is disclosed. In JP-A-2016-133469, physical quantity measurement processing is performed based on a clock signal from the oscillation circuit, but the oscillation frequency is adjusted so as to suppress reduction in measurement accuracy due to interference.

The temperature characteristics of the drive frequency and the temperature characteristics of the drive frequency are different from each other and thus, in the method of JP-A-2016-133469, there is a concern that interference may not be sufficiently suppressed depending on a temperature range.

Furthermore, there are individual differences in the drive frequency by vibrator elements (physical quantity transducers) and thus, a process of individually measuring a drive frequency or the like is required in adjustment of the oscillation frequency disclosed in JP-A-2016-133469. The oscillation frequency may fluctuate due to aged deterioration of the oscillation circuit and thus, the adjustment of the oscillation frequency becomes complicated due to taking aged deterioration into consideration.

SUMMARY

An advantage of some aspects of the invention is to solve at least a part of the problems described above, and the invention can be implemented as the following forms or embodiments.

An aspect of the invention relates to a circuit device which includes a drive circuit configured to drive a physical quantity transducer by a drive signal, a PLL circuit configured to generate a clock signal by a phase locked loop (PLL) operation by using the drive signal as a reference signal, and a measurement circuit that includes a circuit which is operated by an operation signal based on the clock signal and performs measurement processing based on a measurement signal from the physical quantity transducer, and in a case where it is set that a frequency of the drive signal is fdr, a frequency of the clock signal is fck, i is an integer of 1 or more, j is an integer of 1 or more, and a frequency of the operation signal is fck/I, the PLL circuit is configured to generate the clock signal having a frequency of $j \times fdr \neq fck/i$.

According to the aspect of the invention, in the circuit device, which includes the measurement circuit including the circuit which is operated by the operation signal based on the clock signal, the PLL circuit is configured to generate the clock signal by the PLL operation by using the drive signal of the physical quantity transducer as the reference signal. Thus, the frequency of the clock signal is dynamically changed according to the frequency of the drive signal which is the reference signal and thus, it is possible to reliably suppress interference between the operation signal and the drive signal.

In the aspect of the invention, the PLL circuit may be a fractional PLL circuit.

With this configuration, it is possible to appropriately set the frequency of the clock signal to a frequency at which interference is avoided.

In the aspect of the invention, the PLL circuit may include a frequency division circuit for frequency-dividing the clock signal and a phase comparator to which a frequency-divided clock signal from the frequency division circuit and the drive signal are input, and a frequency division ratio of the frequency division circuit may be a non-integer.

With this configuration, it is possible to appropriately set the frequency of the clock signal to a frequency at which interference is avoided.

In the aspect of the invention, the PLL circuit may include a first frequency division circuit for frequency-dividing the clock signal, a second frequency division circuit for frequency-dividing the drive signal, and a phase comparator to which a first frequency-divided clock signal from the first frequency division circuit and a second frequency-divided clock signal from the second frequency division circuit are input, and in a case where it is set that the frequency division ratio of the first frequency division circuit is N and the frequency division ratio of the second frequency division circuit is M, N/M may be a non-integer.

With this configuration, it is possible to appropriately set the frequency of the clock signal to a frequency at which interference is avoided.

In the aspect of the invention, the measurement circuit may be configured to perform a measurement operation with a signal based on the drive signal.

With this configuration, the clock signal from the PLL circuit is not used for the measurement operation and thus, it is possible to suppress influence of jitters generated in the PLL circuit and to perform a measurement operation with high accuracy.

In the aspect of the invention, the circuit which is operated by the operation signal may include at least one of an A/D conversion circuit, a digital signal processing circuit, and an interface unit.

With this configuration, it is possible to operate various circuits by an operation signal based on the clock signal from the PLL circuit and thus, it becomes possible to operate the circuit at a high speed and the like.

In the aspect of the invention, the PLL circuit may include a voltage-controlled oscillator (VCO) and the VCO may be any one of a CR oscillation circuit, an LC oscillation circuit, and a ring oscillator.

With this configuration, it is possible to realize the VCO included in the PLL circuit by various oscillation circuits.

Another aspect of the invention relates to a physical quantity measurement device including any one of the circuit devices described above and the physical quantity transducer.

Another aspect of the invention relates to an electronic device including any one of the circuit devices described above.

Another aspect of the invention relates to a vehicle including any one of the circuit devices described above.

BRIEF DESCRIPTION OF THE DRAWINGS

The invention will be described with reference to the accompanying drawings, wherein like numbers reference like elements.

Fig. 1 is a diagram illustrating a configuration example of a circuit device of a present embodiment.
Fig. 2 is a graph for explaining a method for setting a frequency of a clock signal by avoiding an interference frequency.
Fig. 3 is another graph for explaining the method for setting the frequency of the clock signal by avoiding the interference frequency.
Fig. 4 is a diagram illustrating a configuration example of the circuit device, an electronic device, a gyro sensor (physical quantity measurement device) of the embodiment.
Fig. 5 is a diagram illustrating a detailed configuration example of the circuit device of the embodiment.
Fig. 6 is a diagram for explaining an operation of a measurement circuit by an operation signal based on a clock signal.
Fig. 7 is a graph for explaining the interference frequency.
Fig. 8 is a diagram illustrating a configuration example of a PLL circuit.
Fig. 9 is a diagram illustrating another configuration example of the PLL circuit.
Fig. 10 is a diagram for explaining a frequency division operation of a fractional PLL circuit.
Fig. 11 is graph for explaining the method for setting the frequency of the clock signal by avoiding the interference frequency.
Fig. 12 is a conceptual diagram schematically illustrating a configuration of an automobile as a specific example of a vehicle.

DESCRIPTION OF EXEMPLARY EMBODIMENTS

In the following, preferred embodiments of the invention will be described in detail. The embodiments to be described below do not unduly limit contents of the invention described in the appended claims and all of the configurations described in the embodiments are not necessarily indispensable as means for solving the invention.

1. Circuit Device

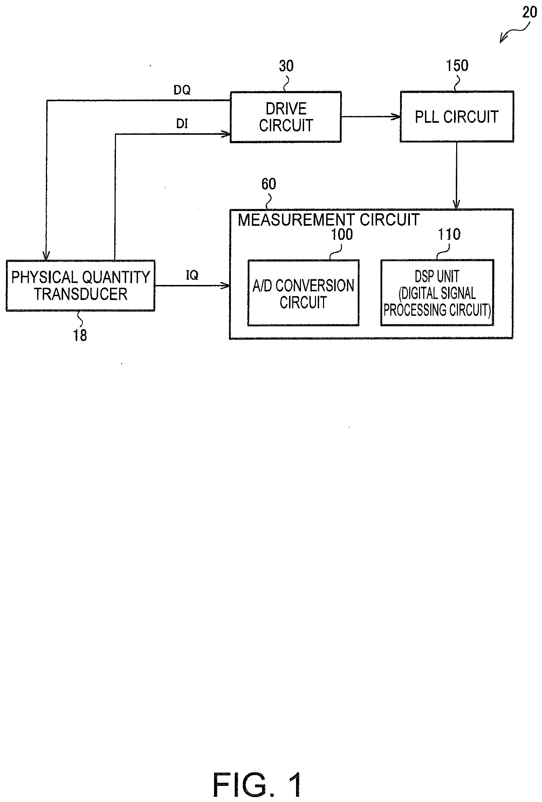

Fig. 1 illustrates a basic configuration example of a circuit device 20 (measurement device) of the embodiment. The circuit device 20 of the embodiment includes a drive circuit 30, a measurement circuit 60 and a PLL circuit 150. The circuit device 20 and a physical quantity transducer 18 constitute a physical quantity measurement device (sensor device). The circuit device 20 and the physical quantity measurement device of the embodiment are not limited to a configuration of Fig. 1, and various modifications can be made by omitting a portion of constitutional elements from the configuration or adding other constitutional elements thereto.

The drive circuit 30 receives a feedback signal DI from the physical quantity transducer 18 and drives the physical quantity transducer 18. For example, the drive circuit 30 receives the feedback signal DI from the physical quantity transducer 18 and outputs a rectangular wave or sinusoidal drive signal DQ to the physical quantity transducer 18. With this, the physical quantity transducer 18 is driven at a constant drive frequency, for example, vibrates or the like at a frequency in accordance with a drive frequency. In the following, the frequency (drive frequency) of the drive signal DQ is assumed to be fdr. The physical quantity transducer 18 here is an element or a device that measures a physical quantity. The physical quantity is, for example, an angular velocity, angular acceleration, velocity, acceleration, distance, pressure, sound pressure, magnetic amount, or time.

The PLL circuit 150 generates a clock signal by a PLL operation in which the drive signal DQ from the drive circuit 30 is used as a reference signal. Details of the PLL circuit 150 will be described later.

A measurement signal IQ from the physical quantity transducer 18 is input to the measurement circuit 60. Then, the measurement circuit 60 performs measurement processing based on the measurement signal IQ (sensor signal) from the physical quantity transducer 18. For example, the measurement circuit 60 performs measurement processing of a physical quantity (desired signal) corresponding to the measurement signal IQ. For example, the measurement circuit 60 outputs measurement data corresponding to the physical quantity. Further, the measurement circuit 60 includes a circuit which is operated by an operation signal based on the clock signal generated by the PLL circuit 150. In Fig. 1, an A/D conversion circuit 100 and a DSP unit 110 (digital signal processing circuit) are provided in the measurement circuit 60 as the circuit which is operated by the operation signal based on the clock signal.

The circuit which is operated by the operation signal based on the clock signal is not limited to the circuits described above. For example, only one of the A/D conversion circuit 100 and the DSP unit 110 may be provided as the circuit which is operated by the operation signal, or a circuit which measures a physical quantity and which is different from the A/D conversion circuit 100 and the DSP unit 110 may be provided. As will be described later, an interface unit 144 of the circuit device 20 may be operated by the operation signal based on the clock signal.

The operation signal based on the clock signal may be a signal obtained by frequency-dividing the clock signal or may be a signal (clock signal itself or signal obtained by buffering the clock signal) having the same frequency as that of the clock signal.

For example, in Fig. 1, the operation signal based on the clock signal is a sampling clock signal of the A/D conversion circuit 100 and an operation clock signal of the DSP unit 110. These sampling clock signal and operation clock signal are signals obtained by frequency-dividing the clock signal. For example, the A/D conversion circuit 100 performs an input signal sampling operation based on the sampling clock signal which is the operation signal. Then, the A/D conversion circuit 100 performs A/D conversion of the signal sampled based on the sampling clock signal. The DSP unit 110 performs digital signal processing based on the operation clock signal which is the operation signal. For example, digital filter processing (low pass filter processing or the like) is performed as digital signal processing. Otherwise, various digital correction processing is performed.

Here, it is set that the frequency of the clock signal output from the PLL circuit 150 is fck, i and j are integers of 1 or more, and the frequency of the operation signal such as the sampling clock signal is fck/i. In a case of $i \geq 2$, i corresponds to a frequency division ratio of the clock signal and fck/i is the frequency of the operation signal such as the sampling clock signal frequency-divided by the frequency division ratio i.

In this case, in the embodiment, the PLL circuit 150 generates a clock signal having a frequency of $j \times$ fdr $\neq$ fck/i. In other words, the frequency of the clock signal (or signal obtained by frequency-dividing the clock signal) is set so as to avoid a relationship of being an integer ratio between the frequency of the clock signal and the frequency of the drive signal. More preferably, in a case where the k is an integer of 1 or more, the PLL circuit 150 generates a clock signal having a frequency of $j \times$ fdr $\neq k \times$ fck/i. For example, a clock signal having a frequency at which $j \times$ fdr $\neq k \times$ fck/i is established when k = 1 and $j \times$ fdr $\neq k \times$ fck/i is established when k is an integer 2 or more (a predetermined value or less) is generated.

Thus, the PLL circuit 150 generates a clock signal having a frequency obtained by avoiding an interference frequency. The A/D conversion circuit 100 and the DSP unit 110 of the measurement circuit 60 operate based on the operation clock signal and the sampling clock signal based on the clock signal.

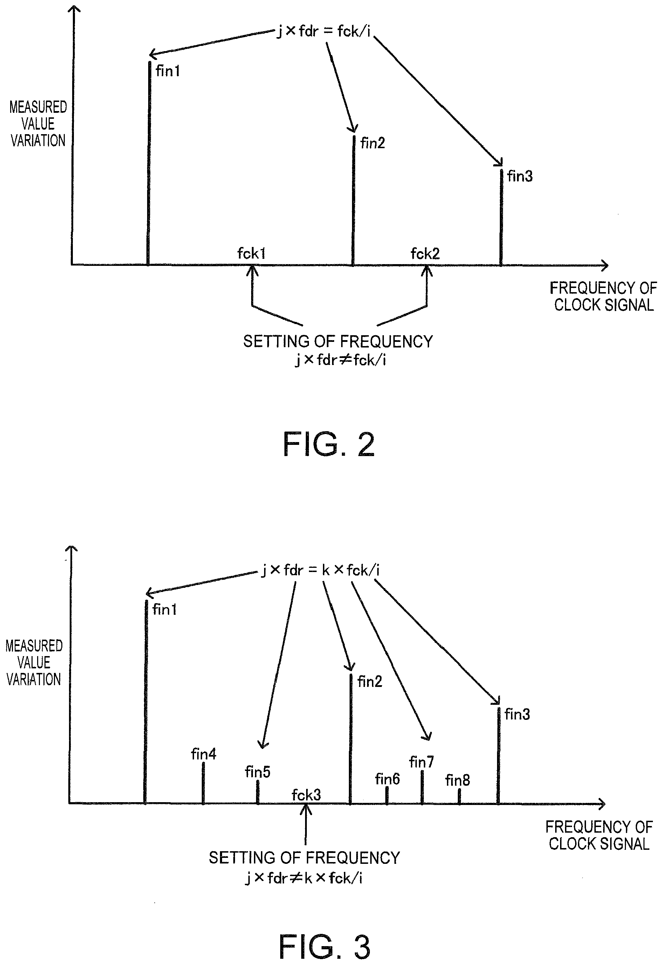

Figs. 2 and 3 are graphs for explaining a method of the embodiment for setting the frequency of the clock signal to the frequency obtained by avoiding the interference frequency.

In Fig. 2, the horizontal axis represents a frequency of a clock signal and the vertical axis represents measured value variation (angular velocity code variation or the like). In Fig. 2, fin 1, fin 2, and fin 3 are interference frequencies and measured value variation of the measurement circuit 60 occur at the interference frequencies. For example, as will be described later, in the configuration of the circuit device 20 of the embodiment, a situation in which a drive frequency component (harmonic component, fundamental mode component) enters around from the drive circuit 30 side to the measurement circuit 60 side occurs. Then, an input signal on which noise of the drive frequency component is superimposed is input to the A/D conversion circuit 100. In this case, when the A/D conversion circuit 100 samples with the sampling clock signal obtained by frequency-dividing the clock signal, the measured value variation occurs at the interference frequency at which the drive frequency component and the sampling frequency component coincide and measurement performance of the measurement circuit 60 deteriorates.

For example, as illustrated in Fig. 2, the interference frequency is the frequency of the clock signal when $j \times fdr = fck/i$ is established. That is, assuming that the interference frequency is fin, in the case of fck = fin, a relational expression of $j \times fdr = fck/i$ is established. For example, in Fig. 2, in a case where fin 1, fin 2, and fin 3 are interference frequencies and fck = fin 1, fin 2, and fin 3, interference conditions of $j \times fdr = fck/i = fin 1/i$, $j \times fdr = fck/i = fin 2/i$, $j \times fdr = fck/i = fin 3/i$ are respectively established.

As illustrated in Fig. 2, in the embodiment, the frequency fck of the clock signal is set to a frequency obtained by avoiding the interference frequencies fin 1, fin 2, and fin 3. For example, the frequency fck = fck 1 of the clock signal is an intermediate frequency between the interference frequencies fin 1 and fin 2, and the frequency fck = fck 2 is an intermediate frequency between the interference frequencies fin 2 and fin 3.

As such, the frequency of the clock signal is set to the frequency obtained by avoiding the interference frequency so as to make it possible to reduce deterioration of measurement performance of the measurement circuit 60 due to occurrence of the measured value variation. This is realized in such a way that the PLL circuit 150 operates to set the frequency of the clock signal to the frequency obtained by avoiding the interference frequency. Furthermore, the frequency division ratio of the frequency division circuit included in the PLL circuit 150 is set so that the frequency of the clock signal avoids the interference frequency.

In Fig. 3, the horizontal axis represents the frequency of the clock signal and the vertical axis represents the measured value variation. In Fig. 3, fin 1 to fin 3 and fin 4 to fin 8 are interference frequencies and measured value variations of the measurement circuit 60 occur at the interference frequencies. In the interference frequencies fin 1 to fin 3, the measured value variation is large and in the interference frequencies fin 4 to fin 8, the measured value variation is small as compared with that of fin 1 to fin 3.

In Fig. 3, the interference frequency is a frequency when $j \times fdr = k \times fck/i$ is established. That is, Fig. 2 corresponds to a case where k = 1 under the interference condition of $j \times fdr = k \times fck/i$. On the other hand, Fig. 3 corresponds to a case where k = 1 and k ≥ 2 under the interference condition of $j \times fdr = k \times fck/i$. The interference frequencies in a case where k = 1 are fin 1 to fin 3, and the measured value variation is large at these interference frequencies. On the other hand, the interference frequencies in a case where k ≥ 2 are fin 4 to fin 8, and the measured value variation is smaller than that of fin 1 to fin 3 at these interference frequencies.

As illustrated in Fig. 3, in the embodiment, the frequency fck of the clock signal is set to a frequency obtained by avoiding the interference frequencies fin 1 to fin 3 and fin 4 to fin 8. For example, the frequency fck = fck 3 of the clock signal is an intermediate frequency between the interference frequencies fin 5 and fin 2.

With this, it is possible to reduce deterioration of the measurement performance of the measurement circuit 60 due to occurrence of the measured value variation. As the k increases, the measured value variation due to interference decreases. When the measured value variation due to interference is less than or equal to other noises (measured value variation due to factors other than interference), even if interference occurs, the influence on measurement accuracy is small. Accordingly, the condition of $j \times fdr \neq k \times fck/i$ does not need to be satisfied for all k with being k ≥ 1 and the condition may be established with a somewhat small value (for example, $1 \leq k \leq 3$ as in the example to be described later).

In the method of the related art prior to the JP-A-2016-133469 described in JP-A-2016-133469, a circuit (A/D conversion circuit 100 and DSP unit 110) of the measurement circuit 60 is operated by a signal based on a drive signal DQ of the drive circuit 30. The frequency of the drive signal DQ is not so high (for example, 50 to 150 KHz) and thus, a high-speed operation of the circuit cannot be implemented. For example, a high-speed A/D conversion operation of the A/D conversion circuit 100 and high-speed digital signal processing of the DSP unit 110 cannot be implemented.

On the other hand, in the method of JP-A-2016-133469, for example, a high-speed original oscillation clock of such as 5 MHz or more is generated by the oscillation circuit of the clock signal generation circuit and the A/D conversion circuit 100 and the DSP unit 110 are operated using a sampling clock signal obtained by frequency-dividing the original oscillation clock or an operation clock signal. Accordingly, it is possible to end processing in each of the circuits at high speed and to implement processing that could not be realized at low frequency signals, and the like.

However, when the circuit of the measurement circuit 60 is operated by the operation signal based on the clock signal of the clock signal generation circuit in order to speed up the circuit operation, a problem which did not occur in a case where the circuit of the measurement circuit 60 was operated by the signal based on the drive signal DQ occurs. That is, as described with reference to FIGs. 2 and 3, a problem of interference between the frequency component of the drive signal DQ and the frequency component of the operation signal such as the sampling clock signal occurs and a problem such as deterioration of measurement performance of the measurement circuit 60 is caused.

For example, in the circuit device 20 that measures the physical quantity by the physical quantity transducer 18, there is a possibility that the measurement performance deteriorates due to the interference caused by the drive frequency of the physical quantity transducer 18 in the circuit included in the measurement circuit 60. That is, the measurement circuit 60 includes the A/D conversion circuit 100 and the DSP unit 110 which are circuits operated by operation signals (sampling clock signal and operation clock signal) based on the clock signal. There is a possibility that the measurement circuit 60 including these circuits is influenced by interference caused by the drive frequency of the physical quantity transducer 18 and deterioration of measurement performance of the measurement circuit 60 or the like occurs.

For example, when the drive frequency component enters around the measurement circuit 60 side, an interference frequency problem that the drive frequency component coincides with the frequency component of the operation signal (sampling clock signal and the like) based on the clock signal occurs, as described with reference to FIGs. 2 and 3. When such an interference frequency problem occurs, the measured value variation of the measurement circuit 60 or the like occurs and measurement performance deteriorates.

In contrast, JP-A-2016-133469 discloses a method of suppressing deterioration of measurement performance by setting an oscillation frequency that avoids the interference frequency. However, as can be seen from an equation such as $j \times fdr = fck/i$ and the like, the interference frequency varies according to the drive frequency (fdr). For that reason, in the method of JP-A-2016-133469, it is necessary to switch a target frequency of the oscillation frequency of the oscillation circuit according to which of the plurality of physical quantity transducers 18 (vibrator element 10) having different drive frequencies is connected to the circuit device 20. Even in a case where one kind of vibrator element 10 is targeted, the drive frequency of the vibrator element varies within a predetermined range (for example, a range of RDA to be described later).

For that reason, in the method of JP-A-2016-133469, it is necessary to undergo a complicated process in which fine adjustment of the oscillation frequency is performed in a state where the circuit device 20 and the vibrator element 10 (physical quantity transducer 18) are connected after rough adjustment of the oscillation frequency in accordance with the vibrator element 10 to be used is performed. In particular, in the fine adjustment, fine adjustments are performed in consideration of element variation of the physical quantity transducer 18 (that is, variation in a drive frequency), fluctuation in the oscillation frequency due to aged deterioration, and the like and thus, adjustment difficulty is high and adjustment time also becomes longer. As a result, in the method of JP-A-2016-133469, a decrease in manufacturing efficiency of the circuit device and an increase in cost occur. Since the temperature characteristics (frequency variation due to temperature) of the drive frequency and the oscillation frequency are different, there is also a problem that it is difficult to suppress interference in a wide temperature range.

In this regard, according to the embodiment, the PLL circuit 150 generates the clock signal by the PLL operation in which the drive signal is used as the reference signal. For that reason, even when there is an individual difference (individual difference in the interference frequency) in the drive frequency, a frequency of the clock signal fluctuates according to the drive frequency and thus, interference can be avoided. That is, in the embodiment, strict individual adjustment as in JP-A-2016-133469 is unnecessary, and it is possible to easily and reliably suppress the interference and the decrease in measurement accuracy due to the interference. Interference suppression can be performed in a wide temperature range. 2. Detailed Configuration of Electronic Device, Gyro Sensor, and Circuit Device

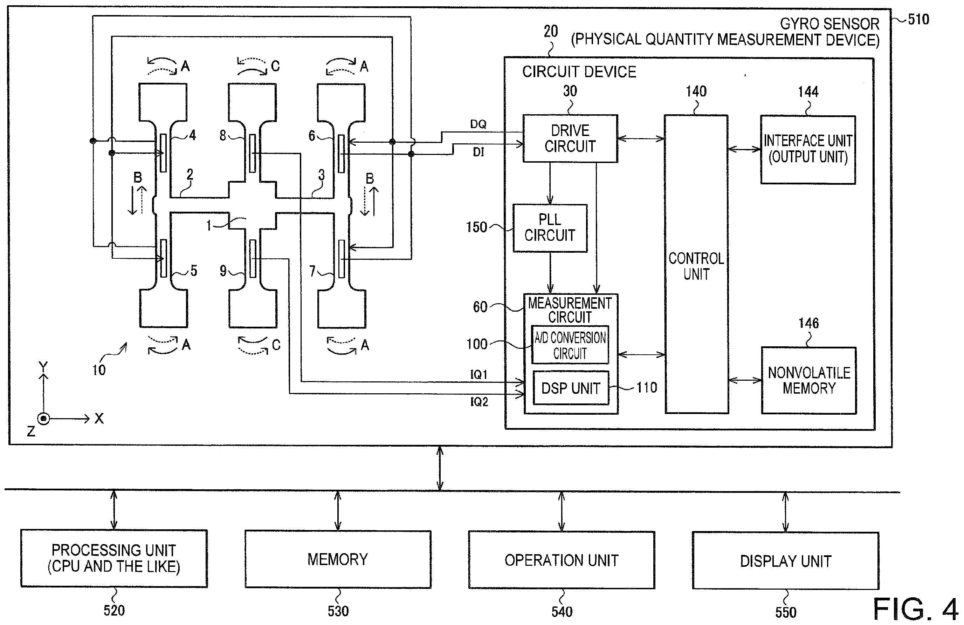

Fig. 4 illustrates a detailed configuration example of the circuit device 20 of the embodiment, a gyro sensor 510 including the circuit device 20 (a physical quantity sensor or a physical quantity measurement device in a broad sense), and an electronic device 500 including the gyro sensor 510.

The circuit device 20, the electronic device 500, and the gyro sensor 510 are not limited to a configuration of Fig. 4, and various modifications can be made by omitting a portion of constitutional elements from the configuration or adding other constitutional elements thereto. As the electronic device 500 of the embodiment, various devices such as a digital camera, a video camera, a smartphone, a mobile phone, a car navigation system, a robot, a biological information measurement device, a game machine, a clock, a health instrument, a portable information terminal, or the like can be assumed. In the following, a case where the physical quantity transducer (angular velocity sensor element) is a piezoelectric type vibrator (vibrator element or vibration gyroscope) and a sensor is a gyro sensor will be described by way of example, but the invention is not limited thereto. The invention is also applicable to, for example, a vibration gyroscope of capacitance measurement type formed from a silicon substrate or the like, a physical quantity transducer which measures a physical quantity equivalent to the angular velocity information or a physical quantity other than angular velocity information, and the like.

The electronic device 500 includes a gyro sensor 510 and a processing unit 520. The electronic device 500 includes a memory 530, an operation unit 540, and a display unit 550. The processing unit 520 (external processing device) realized by a CPU, an MPU or the like performs control of the gyro sensor 510 and the like and overall control of the electronic device 500. The processing unit 520 performs processing based on angular velocity information (physical quantity in a broad sense) measured by the gyro sensor 510. For example, processing for camera shake correction, attitude control, GPS autonomous navigation, and the like are performed based on angular velocity information. The memory 530 (ROM, RAM, and the like) stores a control program and various data and functions as a work area or a data storage area. The operation unit 540 is a unit for allowing a user to operate the electronic device 500, and the display unit 550 displays various kinds of information to the user.

The gyro sensor 510 (physical quantity measurement device) includes the vibrator element 10 and the circuit device 20. The vibrator element 10 (a physical quantity transducer or angular velocity sensor element in a broad sense,) is, for example, a piezoelectric vibrator. Specifically, the vibrator element 10 is, for example, a quartz crystal vibrator. The quartz crystal vibrator is, for example, a quartz crystal vibrator of which the cut angle is AT cut, SC cut, or the like and which adopts in thickness shear vibration. For example, the vibrator element 10 may be a vibrator element built in an oven-controlled crystal oscillator (OCXO) equipped with a thermostatic oven, a vibrator element built in a temperature-compensated crystal oscillator (TCXO) not equipped with a thermostatic oven, or a vibrator element built in a simple packaged crystal oscillator (SPXO), or the like. As the vibrator element 10, a surface acoustic wave (SAW) resonator, a micro electro mechanical system (MEMS) vibrator as a silicon vibrator formed using a silicon substrate, or the like may be adopted. In Fig. 4, an example using a double T-shaped vibrator formed by a Z-cut crystal quartz substrate is illustrated, but the vibrator element 10 of the embodiment is not limited to such a structure. For example, the vibrator element 10 may be a tuning fork type, an H type, or the like.

The circuit device 20 includes a drive circuit 30, a measurement circuit 60, a PLL circuit 150, a control unit 140, an interface unit 144, and a nonvolatile memory 146. Various modifications can be made by omitting a portion of the constitutional elements or adding other constitutional elements to the constitutional elements.

The PLL circuit 150 generates a clock signal by the PLL operation in which a signal from the drive circuit 30 is used as a reference signal. The measurement circuit 60 includes the A/D conversion circuit 100 and the digital signal processing (DSP) unit 110. The A/D conversion circuit 100 performs a sampling operation of an input signal by a sampling clock signal based on a clock signal from the PLL circuit 150 so as to execute A/D conversion. For example, the A/D conversion circuit 100 converts an analog measurement signal (desired signal) into a digital signal (digital data). The DSP unit 110 receives the digital signal from the A/D conversion circuit 100 and performs digital signal processing on the digital signal. The DSP unit 110 is operated by an operation clock signal based on the clock signal from the PLL circuit 150 and executes various digital signal processing such as filter processing.

The control unit 140 performs various control processing based on the clock signal from the PLL circuit 150. For example, the control unit 140 controls the drive circuit 30 and the measurement circuit 60 based on, for example, a clock signal (signal obtained by frequency-dividing the clock signal). The control unit 140 can be realized by a logic circuit (gate array or the like), a processor, or the like.

The interface unit 144 (output unit) is an interface for outputting the measured physical quantity to an external device (for example, processing unit 520 and the like) of the circuit device 20. The interface unit 144 is an interface for performing communication by, for example, the serial peripheral interface (SPI), but another interface such as the inter-integrated circuit (I2C) is also available for the interface unit 144.

The nonvolatile memory 146 stores adjustment information of the clock signal and the like. Here, the adjustment information is, for example, information for setting the frequency division ratio of the frequency division circuit (first frequency division circuit 155 and second frequency division circuit 151 to be described later in a narrow sense) of the PLL circuit 150. As the nonvolatile memory 146, for example, an EPROM, an EEPROM, a flash memory, or the like can be used. As the EPROM, for example, one time PROM (OTP) or the like can be used, and as the OTP, for example, the metal-oxide-nitride-oxide-silicon (MONOS) or the like can be used. A storing device other than a nonvolatile memory (for example, a storing device using a fuse) may be provided in the circuit device 20.

The drive circuit 30 outputs the drive signal DQ to drive the vibrator element 10. For example, the drive circuit 30 receives the feedback signal DI from the vibrator element 10 and outputs the drive signal DQ corresponding to the feedback signal DI so as to excite the vibrator element 10. The measurement circuit 60 receives measurement signals IQ1 and IQ2 (measured current or charges) from the vibrator element 10 driven by the drive signal DQ and measures (extracts) a desired signal (Coriolis force signal) corresponding to the physical quantity applied to the vibrator element 10 from the measurement signals IQ1 and IQ2.

The vibrator element 10 includes a base portion 1, connection arms 2 and 3, drive arms 4, 5, 6, and 7, and measurement arms 8, 9. The measurement arms 8 and 9 extend in the +Y-axis direction and the -Y-axis direction with respect to the rectangular base portion 1. The connection arms 2 and 3 extend in the -X-axis direction and the +X-axis direction with respect to the base portion 1. The drive arms 4 and 5 extend in the +Y-axis direction and the -Y-axis direction with respect to the connection arm 2, and the drive arms 6 and 7 extend in the +Y-axis direction and the -Y-axis direction with respect to the connection arm 3. The X-axis, the Y-axis, and the Z-axis indicate axes of quartz crystal, which are also referred to as an electric axis, a mechanical axis, and an optical axis, respectively.

The drive signal DQ from the drive circuit 30 is input to drive electrodes provided on upper surfaces of the drive arms 4 and 5 and drive electrodes provided on side faces of the drive arms 6 and 7. Signals from the drive electrodes provided on the side surfaces of the drive arms 4 and 5 and the drive electrodes provided on the upper surfaces of the drive arms 6 and 7 are input to the drive circuit 30 as the feedback signal DI. Signals from the measurement electrodes provided on the upper surfaces of the measurement arms 8 and 9 are input to the measurement circuit 60 as the measurement signals IQ1 and IQ2. The common electrodes provided on the side surfaces of the measurement arms 8, 9 are grounded, for example.

When the AC drive signal DQ is applied by the drive circuit 30, the drive arms 4, 5, 6, and 7 perform flexural vibration (excitation vibration) as indicated by the arrow A due to inverse piezoelectric effect. That is, tip end portions of the drive arms 4 and 6 repeat approaching and separating from each other and tip end portions of the drive arms 5 and 7 also perform flexural vibration in which approaching and separating from each other are repeated. In this case, the drive arms 4 and 5 and the drive arms 6 and 7 perform vibration to be line-symmetrical with respect to the Y-axis passing through the center of gravity position of the base portion 1 and thus, the base portion 1, the connection arms 2 and 3, and the measurement arms 8 and 9 hardly vibrate.

In this state, when an angular velocity with the Z-axis as a rotation axis is applied to the vibrator element 10 (when the vibrator element 10 rotates around the Z-axis), the drive arms 4, 5, 6, and 7 vibrate as indicated by the arrow B by the Coriolis force. That is, the Coriolis force in the direction of the arrow B orthogonal to the direction of the arrow A and the direction of the Z-axis acts on the drive arms 4, 5, 6, and 7, so that a vibration component in the direction of the arrow B is generated. The vibration in the direction of the arrow B is transmitted to the base portion 1 via the connection arms 2 and 3 and the measurement arms 8 and 9 perform flexural vibration in the direction of the arrow C. Charge signals generated by piezoelectric effect due to the flexural vibration of the measurement arms 8 and 9 are input to the measurement circuit 60 as the measurement signals IQ1 and IQ2. Here, the vibration of the drive arms 4, 5, 6, and 7 in the arrow B corresponds to vibration in the circumferential direction with respect to the center of gravity position of the base portion 1, and the vibration of the measurement arms 8 and 9 is vibration in the direction of the arrow C opposite to the arrow B in the circumferential direction. The measurement signals IQ1 and IQ2 are signals of which phases are shifted from each other by 90 degrees with respect to the drive signal DQ.

For example, when it is set that the angular velocity of the vibrator element 10 (gyro sensor) around the Z-axis is ω, mass is m, and the vibration velocity is v, the Coriolis force is expressed as Fc = 2m · v · ω. Accordingly, the measurement circuit 60 measures the desired signal which is a signal corresponding to the Coriolis force, so as to make it possible to obtain the angular velocity ω. The processing unit 520 can perform various processing for camera shake correction, attitude control, GPS autonomous navigation or the like by using the obtained angular velocity ω.

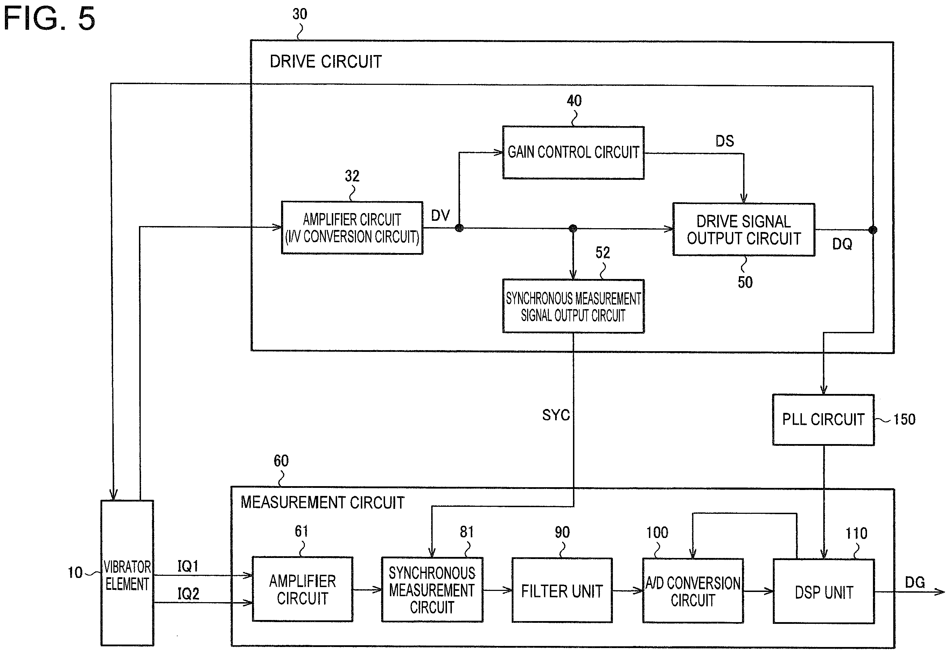

Fig. 5 illustrates a detailed configuration example of the drive circuit 30 and the measurement circuit 60 of the circuit device 20.

The drive circuit 30 includes an amplifier circuit 32 to which the feedback signal DI from the vibrator element 10 is input, a gain control circuit 40 for performing automatic gain control, and a drive signal output circuit 50 for outputting the drive signal DQ to the vibrator element 10 and the PLL circuit 150. The drive circuit 30 also includes a synchronous measurement signal output circuit 52 for outputting a synchronous measurement signal SYC to the measurement circuit 60. The configuration of the drive circuit 30 is not limited to a configuration of Fig. 5, and various modifications can be made by omitting a portion of constitutional elements from the configuration or adding other constitutional elements thereto.

The amplifier circuit 32 (I/V conversion circuit) amplifies the feedback signal DI from the vibrator element 10. For example, the amplifier circuit 32 converts the current signal DI from the vibrator element 10 into the voltage signal DV to be output. The amplifier circuit 32 can be realized by an operational amplifier, a feedback resistive element, a feedback capacitor, or the like.

The drive signal output circuit 50 outputs the drive signal DQ based on the signal DV after being amplified by the amplifier circuit 32. For example, in a case where the drive signal output circuit 50 outputs a rectangular wave (or sine wave) drive signal, the drive signal output circuit 50 can be realized by a comparator or the like.

The gain control circuit (AGC) 40 outputs a control voltage DS to the drive signal output circuit 50 to control the amplitude of the drive signal DQ. Specifically, the gain control circuit 40 monitors the signal DV and controls a gain of an oscillation loop. For example, in the drive circuit 30, in order to keep sensitivity of the gyro sensor constant, it is necessary to keep the amplitude of the drive voltage to be supplied to the vibrator element 10 (drive vibrator element) constant. For that reason, the gain control circuit 40 for automatically adjusting the gain is provided in the oscillation loop of a drive vibration system. The gain control circuit 40 variably and automatically adjusts the gain so that the amplitude (vibration speed v of vibrator element) of the feedback signal DI from the vibrator element 10 becomes constant. The gain control circuit 40 can be realized by a full-wave rectifier that performs full-wave rectification of the output signal DV of the amplifier circuit 32, an integrator that performs integration processing of output signals of the full-wave rectifier, and the like.

The synchronous measurement signal output circuit 52 receives the signal DV after being amplified by the amplifier circuit 32 and outputs the synchronous measurement signal SYC (reference signal) to the measurement circuit 60. The synchronous measurement signal output circuit 52 is realized by a comparator for performing binarization processing of the sine wave (AC) signal DV to generate the rectangular wave synchronous measurement signal SYC, a phase adjustment circuit (phase shifter) for performing phase adjustment of the synchronous measurement signal SYC, and the like.

The measurement circuit 60 includes an amplifier circuit 61, a synchronous measurement circuit 81, a filter unit 90, an A/D conversion circuit 100, and a DSP unit 110. The amplifier circuit 61 receives the first and second measurement signals IQ1 and IQ2 from the vibrator element 10 and performs charge-to-voltage conversion, differential signal amplification, gain adjustment, and the like. The synchronous measurement circuit 81 performs synchronous measurement based on the synchronous measurement signal SYC from the drive circuit 30. The filter unit 90 (low-pass filter) functions as a pre-filter of the A/D conversion circuit 100. The filter unit 90 also functions as a circuit for attenuating unnecessary signals that could not be eliminated by synchronous measurement. The A/D conversion circuit 100 performs the A/D conversion of the signal after synchronous measurement. The DSP unit 110 performs digital signal processing such as digital filter processing and digital correction processing on the digital signal from the A/D conversion circuit 100. The digital correction processing includes, for example, zero point correction processing and sensitivity correction processing.

3. Interference Frequency

In the circuit device 20 that measures the physical quantity such as the angular velocity by driving the vibrator element 10, there is a possibility that measurement performance deteriorates due to interference of the drive frequency of the vibrator element 10 and the sampling clock signal and the like (operation signal) of the A/D conversion circuit 100 of the measurement circuit 60. For example, variation in the angular velocity code or the like occurs at the interference frequency at which the drive frequency component coincides with the sampling frequency component of the A/D conversion circuit 100 and measurement performance deteriorates. In the following, description will be made on the sampling clock signal by way of an example, but it can be thought that the description can be extended to another operation signal (operation clock signal and the like of DSP unit 110).

The drive frequency component represents a fundamental mode component (fundamental frequency component) or a harmonic component (harmonic frequency component) of the drive frequency and the sampling frequency component represents the fundamental frequency component and the harmonic frequency component of the sampling frequency of the A/D conversion circuit 100.

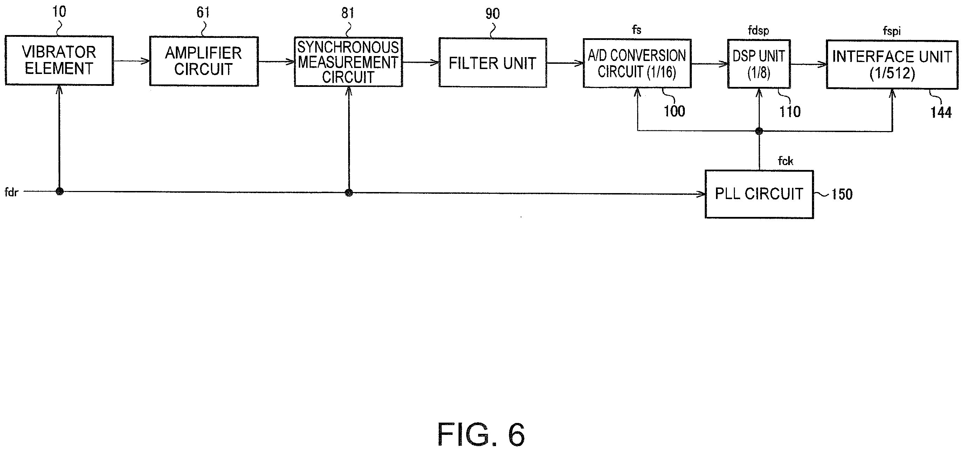

Fig. 6 is a diagram for explaining the sampling clock signal of the A/D conversion circuit 100 supplied to the measurement circuit 60 and the operation clock signal of the DSP unit 110. As illustrated in Fig. 6, the vibrator element 10 is driven at the drive frequency fdr. The drive frequency fdr varies due to the individual difference of the vibrator element 10.

The synchronous measurement circuit 81 performs synchronous measurement processing based on the synchronous measurement signal SYC having the drive frequency fdr. That is, the measurement circuit 60 performs the measurement operation with a signal based on the drive signal. Jitter occurs in the PLL circuit 150 and thus, in a case where the measurement operation is performed based on the clock signal generated by the PLL circuit 150, there is a possibility that measurement accuracy is reduced by the jitter. In the embodiment, the measurement operation (synchronous measurement) is performed based on the drive signal and thus, accuracy deterioration due to jitter can be suppressed.

Here, as for the A/D conversion circuit 100, the DSP unit 110, and the like of the measurement circuit 60, a method of operating the components by a signal (signal obtained by frequency-dividing the drive signal, a signal obtained by buffering the drive signal, and the like) based on the drive signal having the drive frequency fdr is conceivable. However, in this method, in a case where the drive frequency fdr is, for example, approximately 50 KHz, the signal based on the drive signal is 50 KHz or less and thus, a high-speed operation of the A/D conversion circuit 100 and the DSP unit 110 cannot be implemented.

For that reason, in the embodiment, a method in which the PLL circuit 150 generating the clock signal by performing the PLL operation using the drive signal as a reference signal is provided and the operation signal based on the generated clock signal causes the A/D conversion circuit 100 and the DSP unit 110 and the like to operate is adopted. The PLL circuit 150 outputs a clock signal having a frequency obtained by multiplying (strictly speaking, a fractional PLL circuit is used and thus, non-integer multiple of a frequency) the frequency of the drive signal as a reference signal. For example, while the frequency of the drive signal is approximately 50 KHz, the frequency of the clock signal output from the PLL circuit 150 is on the order of MHz.

For example, in Fig. 6, the clock signal of the frequency fck is frequency-divided by i1 and the A/D conversion circuit 100 is operated based on the sampling clock signal of the sampling frequency fs = fck/i1 obtained by frequency division. The clock signal of the frequency fck is frequency-divided by i2, and the DSP unit 110 is operated based on the operation clock signal of frequency fdsp = fck/i2 obtained by frequency division.

The circuit to be operated by the operation signal based on the clock signal is not limited to the A/D conversion circuit 100 and the DSP unit 110. For example, the interface unit 144 may be operated by the operation signal. In this case, the interface unit 144 operates based on the clock signal of the frequency fspi = fck/i3 obtained by frequency-dividing the clock signal of the frequency fck by i3.

For example, i1 to i3 are i1 = 16, i2 = 8, i3 = 512, respectively. However, various modifications can be made with respect to specific values of i1 to i3.

In the circuit device 20 of the embodiment as described above, there is a possibility that a problem of variation in measurement data (angular velocity code) caused by coincidence of the drive frequency component and the operation frequency component (fundamental mode component or harmonic component of the frequency of the operation signal) occurs.

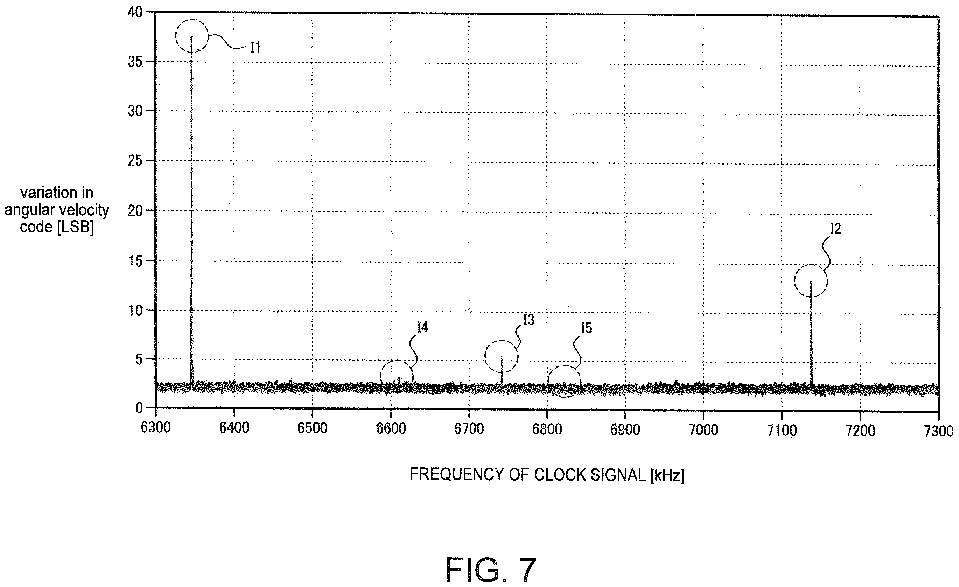

Fig. 7 is a graph for explaining the interference frequency. In Fig. 7, the horizontal axis represents the frequency of the clock signal and the vertical axis represents magnitude of variation in the angular velocity code. A problem of variation in the angular velocity code caused by interference between the drive frequency component and the operation frequency of the measurement circuit 60 side occurs.

For example, it is set that the frequency of the clock signal generated by the PLL circuit 150 is fck, i, j, and k are an integer of 1 or more, and the frequency of the operation signal such as the sampling clock signal is fck/i. In a case of $i \geq 2$, i corresponds to the frequency division ratio of the clock signal, and fck/i is the frequency of the operation signal such as the sampling clock signal frequency-divided by the division ratio i.

In this case, the interference frequency is an oscillation frequency when $j \times fdr = k \times fck/i$ is established. That is, in a case of fck = fin, when the interference frequency is assumed to be fin, the relational expression of $j \times fdr = k \times fck/i$ is established.

For example, at the interference frequency indicated by I1 in Fig. 7, the relational expression of $8 \times fdr = fs = fck/i$ is established. For example, when the interference frequency of I1 is assumed to be fck = fin 1, the relational expression of $8 \times fdr = fin 1/i$ is established. This corresponds to a case of j = 8, k = 1 in the relational expression (interference condition) of $j \times fdr = k \times fck/i$.

At the interference frequency indicated by I2, the relational expression of $9 \times fdr = fs = fck/i$ is established. For example, when the interference frequency of I2 is assumed to be fck = fin 2, the relational expression of $9 \times fdr = fin 2/i$ is established. This corresponds to a case of j = 9, k = 1 in the relational expression of $j \times fdr = k \times fck/i$.

At the interference frequency indicated by I3, the relational expression of $17 \times fdr = 2 \times fs = 2 \times fck/i$ is established. For example, when the interference frequency of I3 is assumed to be fck = fin 3, the relational expression of $17 \times fdr = 2 \times fin 3/i$ is established. This corresponds to a case of j = 17, k = 2 in the relational expression of $j \times fdr = k \times fck/i$.

At the interference frequency indicated by I4, the relational expression of $25 \times fdr = 3 \times fs = 3 \times fck/i$ is established. For example, when the interference frequency of I4 is assumed to be fck = fin 4, the relational expression of $25 \times fdr = 3 \times fin 4/i$ is established. This corresponds to a case of j = 25, k = 3 in the relational expression of $j \times fdr = k \times fck/i$.

At the interference frequency indicated by I5, the relational expression of $26 \times fdr = 3 \times fs = 3 \times fck/i$ is established. For example, when the interference frequency of I5 is assumed to be fck = fin 5, the relational expression of $26 \times fdr = 3 \times fin 5/i$ is established. This corresponds to a case of j = 26, k = 3 in the relational expression of $j \times fdr = k \times fck/i$.

The interference frequency determined by j and k that satisfy $8 < (j/k) < 9$ corresponds to the interference frequency between I1 and I2. For example, if k = 4, there are interference frequencies other than I3 to I5 between I1 and I2 as in the case of j = 33, 34, or 35. However, as can be seen from the variation in the angular velocity code, as the k increases, influence due to interference also decreases and the influence becomes a level that can be sufficiently buried in other noises. Accordingly, here, an example in which $1 \leq k \leq 3$ is taken into account as the range of k will be described.

In the interference frequency, the interference condition expressed by the relational expression of $j \times fdr = k \times fs = k \times fck/i$ is established. Here, $j \times fdr$ corresponds to a harmonic component ($j \geq 2$) or a fundamental mode component (j = 1) of the drive frequency fdr. fs = fck/i is the sampling frequency (broadly speaking, frequency of the operation signal) of the A/D conversion circuit 100. Accordingly, the interference condition $j \times fdr = k \times fck/i$ is a condition that the harmonic component ($j \geq 2$) and the fundamental mode component (j = 1) of the drive frequency fdr coincide with the frequency which is k times the sampling frequency fck/i.

The variation in angular velocity code at the interference frequency illustrated in Fig. 7 is caused by matters that the frequency component (drive frequency component) of the unnecessary signal mixed in the input signal of the A/D conversion circuit 100 is folded back to a signal band by the sampling operation of the A/D conversion circuit 100 or the like. Accordingly, the variation in the angular velocity code at the interference frequency is actually absent in a case where $j \times fdr$ and $k \times fs$ are completely identical, but appears conspicuously in a case where a frequency difference $\Delta f$ between $j \times fdr$ and $k \times fs$ is sufficiently small. Specifically, in a case where the frequency difference $\Delta f$ is lower than a frequency (for example, 200 Hz to 10 Hz) of a signal band which is a frequency band of a desired signal, folding noise due to the frequency difference $\Delta f$ appears in the signal band, so that a problem of the variation (shaking) in angular velocity code occurs. In a case where the frequency difference $\Delta f$ is large, the folding noise is sufficiently reduced by the low-pass filter for band limitation of the DSP unit 110, so that variation in angular velocity code does not occur. As described above, the interference frequency to be avoided in the embodiment can be said to have a given frequency width (signal bandwidth $\Delta f$).

In the embodiment, a method of setting the frequency of the clock signal to a frequency obtained by avoiding such an interference frequency is employed. That is, the frequency fck is set so that $j \times fdr \neq fck/i$ is satisfied in a case where it is set that the clock signal frequency is fck, i and j are integers of 1 or more, and the frequency of the operation signal is fck/i.

When the frequency fck of the clock signal is set so that $j \times fdr \neq fck/i$ is satisfied, the frequency fck can be set to a frequency obtained by avoiding the interference frequency indicated by I1 and I2 in Fig. 7. Accordingly, it is possible to reduce occurrence of the variation in angular velocity code having a large value indicated by I1 and I2 and to reduce deterioration in measurement performance.

Furthermore, in the embodiment, it is desirable to set the frequency fck of the clock signal so that $j \times fdr \neq k \times fck/i$ is satisfied in a case where k is an integer of 1 or more (and a predetermined value or less). That is, the frequency fck is set to a frequency obtained by avoiding not only the interference frequency in the case of k = 1 as illustrated at I1 and I2 of Fig. 7 but also the frequency obtained by avoiding the interference frequency in the case of k ≥ 2 as illustrated in I3 to I5. By doing as described above, it is possible to suppress not only occurrence of the variation in angular velocity code having a large value as illustrated by I1 and I2, but also occurrence of the variation in angular velocity code having a comparatively small value as indicated by I3 to I5. 4. Details of PLL Circuit and Setting Example of Frequency Division Ratio

In the embodiment, adjustment of the frequency fck of the clock signal which satisfies $j \times fdr \neq k \times fck/i$ is realized by the PLL circuit 150.

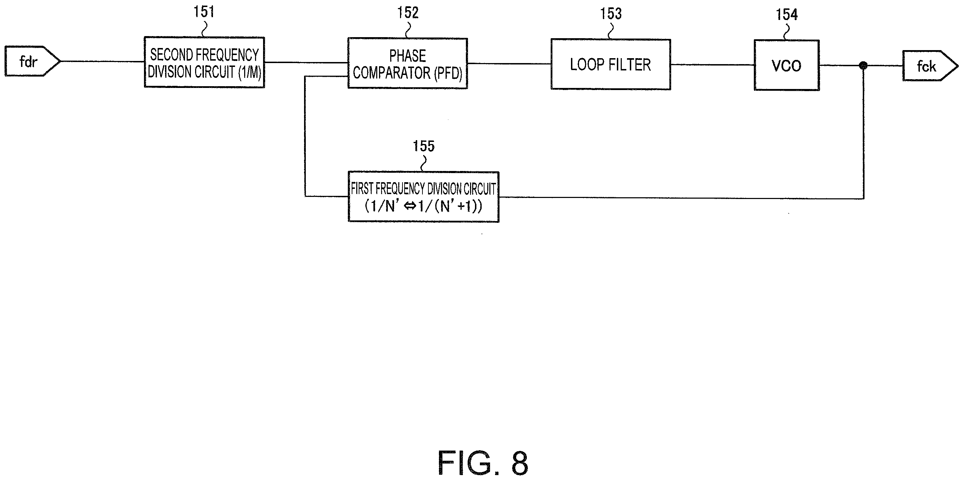

Fig. 8 is a detailed configuration example of the PLL circuit 150 of the embodiment. Fig. 8 illustrates an example of an analog PLL circuit. The PLL circuit 150 includes a second frequency division circuit 151 for frequency-dividing a drive signal which is a reference signal, a phase comparator 152 (phase frequency detector (PFD)), a loop filter 153, a voltage-controlled oscillator (VCO) 154, and a first frequency division circuit 155 for dividing the frequency of the clock signal output from the PLL circuit 150.

The phase comparator 152 compares a phase of a first frequency-divided clock signal from the first frequency division circuit 155 with that of a second frequency-divided clock signal from the second frequency division circuit 151. The phase comparator 152 may include a charge pump. The phase comparator 152 is connected to the loop filter 153. The loop filter 153 is connected to the VCO 154. An oscillation signal from the VCO 154 is output as a clock signal and input to the first frequency division circuit 155. Here, the VCO 154 is one of a CR oscillation circuit, an LC oscillation circuit, and a ring oscillator. Thus, it is possible to configure the PLL circuit 150 using various oscillation circuits (oscillators).

The PLL circuit 150 is not limited to a configuration of Fig. 8, and various modifications can be made by omitting a portion of constitutional elements from the configuration or adding other constitutional elements thereto . For example, the second frequency division circuit 151 may be omitted and the drive signal may be input to the phase comparator 152.

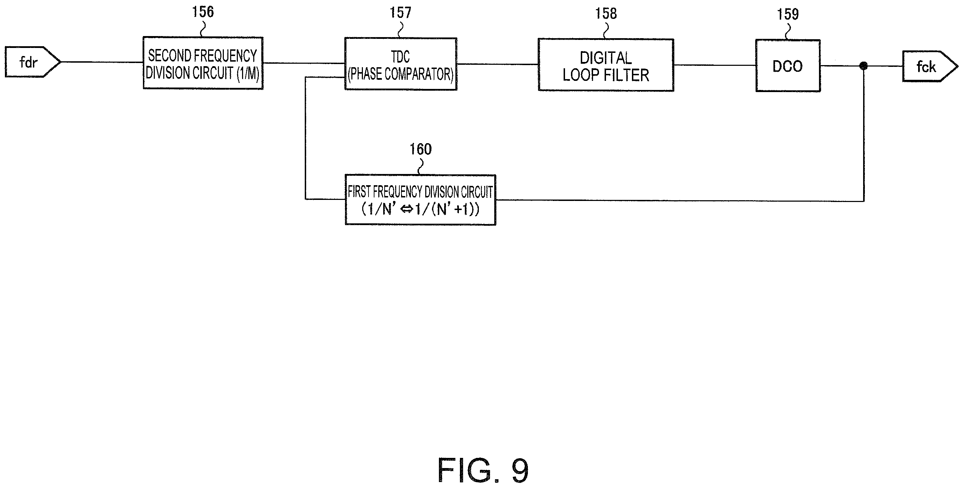

Fig. 9 illustrates another configuration example of the PLL circuit 150 of the embodiment. An example of a digital PLL circuit is illustrated in Fig. 9. The PLL circuit 150 includes a second frequency division circuit 156, a time-to-digital converter (TDC) 157 which is a phase comparator, a digital loop filter 158, a digital-controlled oscillator (DCO) 159, and a first frequency division circuit 160. The first frequency division circuit 160 and the second frequency division circuit 156 are digital circuits such as a programmable frequency division circuit.

In Fig. 9, the digital loop filter 158, the first frequency division circuit 160, and the second frequency division circuit 156 are illustrated as having different configurations, but it is also possible to implement a modification example in which these components are configured as one digital computation unit. In addition, as the PLL circuit 150 of the embodiment, various PLL circuits such as an analog PLL, a digital PLL, an all-digital PLL (ADPLL), and the like can be used. In the following, the PLL circuit 150 will be described using an example in which the PLL circuit 150 is the analog PLL of Fig. 8.

In a case where the frequency division ratio of the first frequency division circuit 155 is set as N and the frequency division ratio of the second frequency division circuit 151 is set as M, the frequency fdr of the drive signal and the frequency fck of the clock signal satisfy (fdr/M) = (fck/N). That is, it becomes that fck = (N/M) × fdr. Here, in a case where N/M is an integer and is a multiple of i, when it is set that k = 1 and i × j = (N/M), fck = (N/M) × fdr can be transformed into $j \times fdr = k \times fck/i$. That is, in a case where N/M is an integer, there is a possibility that the frequency fck that satisfies fck = (N/M) × fdr becomes an interference frequency. Furthermore, there is also a case of k = 1 and thus, there is a concern that the measured value variation becomes large.

Accordingly, N/M is a non-integer in the PLL circuit 150 of the embodiment. In other words, in frequency adjustment of the clock signal according to the embodiment, the frequency division ratio of the frequency division circuit is set so that N/M becomes a non-integer. When N/M is a non-integer, the frequency fck of the clock signal can be set to a frequency obtained by avoiding the interference frequency (fin 1 to fin 3 in Fig. 2 or I1 and I2 in Fig. 7) in the case of at least k = 1. In this case, N/M only has to be a non-integer, and it is also possible that both N and M are integers.

However, it is conceivable that the second frequency division circuit 151 is omitted. In this case, it becomes that fck = N × fdr. In a case where N is an integer and a multiple of i, when it is set that k = 1 and i × j = N, fck = N × fdr can be transformed into $j \times fdr = k \times fck/i$. That is, when N is an integer, there is a possibility that the frequency fck satisfying the relation expression of fck = N × fdr becomes an interference frequency. Furthermore, there is also a case of k = 1 and thus, there is a concern that the measured value variation becomes large.

Accordingly, in the embodiment, the frequency division ratio (N) of the first frequency division circuit 155 is desirably a non-integer. In other words, in frequency adjustment of the clock signal according to the embodiment, the frequency division ratio of the first frequency division circuit 155 is set so that N becomes a non-integer. By doing as described above, it is possible to set the frequency fck of the clock signal to the frequency obtained by avoiding the interference frequency even in a case where the second frequency division circuit 151 is omitted or the like.

When the matters as described above are taken into consideration, the PLL circuit 150 is desirably a fractional PLL circuit.

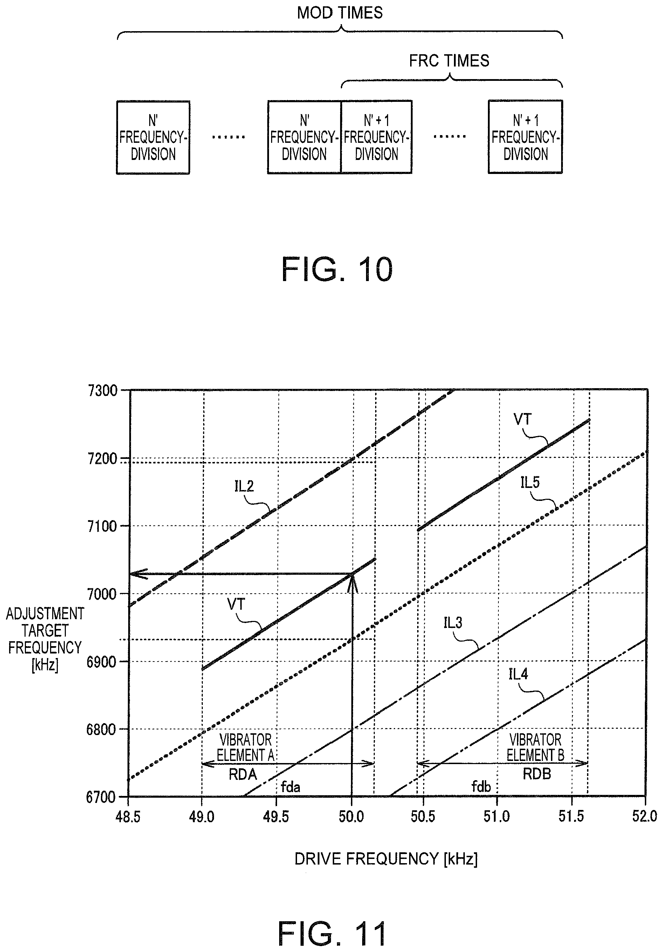

Fig. 10 is a diagram for explaining the operation of the fractional PLL circuit. The horizontal axis direction in Fig. 10 represents time. In the fractional PLL circuit, in a case where the frequency division operation of MOD times is regarded as one sequence, the frequency division ratio in the frequency division operation of (MOD - FRC) times in the one sequence is set as N' and the frequency division ratio in the frequency division operation of FRC times is set as N' + 1. Here, MOD, FRC, N' are integers and MOD > FRC is satisfied. In the fractional PLL circuit, the operation of Fig. 10 is repeated in each sequence. In the repetition, $\Delta\Sigma$ modulation is performed so as to reduce noise.

In such a case, it can be considered that the frequency division ratio N of the first frequency division circuit 155 is a number between N' and N' + 1. Specifically, N and N' satisfy the relationship of the following expression (1) .

$$N = \{N' \times (MOD - FRC) + (N' + 1) \times FRC\}/MOD \quad (1)$$

By doing as described above, it is possible to set a non-integer value (value between N' which is an integer and N' + 1 which is an adjacent integer) as the frequency division ratio N and thus, it is possible to set the frequency of the clock signal to the frequency obtained by avoiding the interference frequency, in particular, to the frequency obtained by avoiding the interference frequency, which corresponds to k = 1 and which greatly influences measurement variation.

Fig. 11 is a graph for explaining an adjustment method of the frequency fck of the clock signal according to the embodiment. In Fig. 11, the horizontal axis represents the drive frequency fdr and the vertical axis represents the target frequency (target value of fck) for frequency adjustment.

In Fig. 11, IL2 to IL5 are lines corresponding to the interference frequencies I2 to I5 described with reference to Fig. 7. The line IL1 corresponding to the interference frequency I1 is located lower than IL4 and is omitted in Fig. 11.

On the interference frequency lines IL2 to IL5, a problem of the variation in angular velocity code occurs . Here, an example in which a frequency between the interference frequency I5 and the interference frequency 12 is set as the target frequency will be described.

In Fig. 11, examples of the vibrator element A and the vibrator element B are illustrated. The drive frequency (typical value) is different between the vibrator element A and the vibrator element B. For example, as the vibrator element 10 that is paired with the circuit device 20 and incorporated in the package, there are two kinds of vibrator elements A and B. The vibrator elements A and B having different drive frequencies are used such that it is also possible to reduce interference between axes in a multi-axis gyro sensor, for example.

As illustrated in Fig. 11, there are individual differences in the drive frequencies of the vibrator elements A and B, the drive frequency of the vibrator element A varies within the range of RDA, and the drive frequency of the vibrator element B varies within the range of RDB. The RDA is a variation range in the drive frequency centered on the typical value fda of the drive frequency of the vibrator element A. The RDB is a variation range of the drive frequency centered on the typical value fdb of the drive frequency of the vibrator element B.

According to the method of JP-A-2016-133469, depending on which one of the vibrator element A and the vibrator element B is connected to the circuit device 20 (depending on which one of the vibrator elements and the circuit device constitute the physical quantity measurement device), the target frequency should be changed. Furthermore, in a state where the circuit device 20 is connected to the vibrator element A and packaged as a physical quantity measurement device, it is necessary to measure the drive frequency so as to specify the drive frequency of the vibrator element A. For example, as illustrated in Fig. 11, in a case where an adjustment line (target frequency line) VL is set between the interference frequency lines IL2 and IL5, it is necessary to obtain the target frequency from the measured drive frequency and the adjustment line VL. That is, in order to perform high accurate adjustment, it is necessary to actually measure characteristics of the vibrator element 10 connected to the circuit device 20 individually and thus, the burden of adjustment is large.

In this regard, in the embodiment, the frequency adjustment is performed by setting the frequency division ratios N and M of the frequency division circuit in the relationship of fck = (N/M) $\times$ fdr. The fck changes in association with the drive frequency fdr and in Fig. 11 change of the fck becomes a linearly increasing linear function (a linear function passing through the origin) . That is, in the frequency adjustment according to the embodiment, the frequency division ratios N and M may be set so that a straight line represented by (N/M) $\times$ fdr overlaps with the adjustment line VL (so as not to overlap with the line corresponding to the interference frequency). When the frequency division ratio is appropriately set, whatever value the drive frequency of the vibrator element 10 is, the frequency fck of the clock signal can be adjusted to an appropriate value (value according to adjustment line VL) by the PLL operation of the PLL circuit 150. That is, it is possible to omit strict adjustment taking individual differences into consideration.

The oscillation frequency of the VCO 154 included in the PLL circuit 150 fluctuates due to aged deterioration, but the PLL circuit 150 is used so that frequency accuracy can be made equal to accuracy of the reference signal (accuracy of the vibrator element 10). That is, the PLL circuit 150 is used so that fluctuation due to aged deterioration of the frequency fck of the clock signal can be suppressed. Further, although it is assumed that temperature characteristics of the drive frequency and temperature characteristics of the oscillation frequency of the VCO 154 are different from each other, the drive frequency and the frequency of the clock signal are associated with each other by using the PLL circuit 150 and thus, the difference in the temperature characteristics does not cause a problem.

That is, in the method of the embodiment, the frequency adjustment is very easy as compared with the method of JP-A-2016-133469 and the time and cost required for manufacturing the circuit device can be reduced. Furthermore, it is possible to implement the high accurate measurement operation obtained by suppressing the influence by interference in a wide temperature range.

Various specific setting methods of the frequency division ratio are conceivable. For example, a given drive frequency (for example, 50 KHz) is set and an interference frequency at the drive frequency is obtained. An arbitrary value can be used as the drive frequency here, and there is no need to use an actual measurement value of the vibrator element 10. Then, the frequency division ratios N and M are set so that the interference frequency at which fck = (N/M) × fdr is obtained is avoided.

For example, in a case where the sampling frequency fs of the A/D conversion circuit 100 is fs = fck/16 (i = 16), the interference frequency due to the sampling frequency fs is taken into consideration. At I2 in Fig. 7, since j = 9 and k = 1, the interference frequency is 50 KHz × 9 × 16 ÷ 1 = 7.20 MHz. Also, at I5, since j = 26 and k = 3, the interference frequency is 50 KHz × 26 × 16 ÷ 3 = 6.93 MHz. Accordingly, the target frequency in the state where the drive frequency is 50 Hz becomes a frequency larger than 6.93 MHz and smaller than 7.20 MHz.

For example, in a case of M = 1, since it becomes that fck = N × 50 KHz, when the target frequency range can be limited, the range of N can also be limited. After that, values of the N', MOD, and FRC may be set so that the N is within the range.

When the value of the frequency division ratio N can be set, even in a case where the characteristics of the vibrator element 10 (vibrator element A and the vibrator element B) are different or even in a case where the drive frequency varies (such as RDA) due to the individual difference of the vibrator element 10, the frequency division ratio N can be used in common.

5. Vehicle and the like

The method of the embodiment can be applied to the physical quantity measurement device (gyro sensor 510) including the circuit device 20 and the physical quantity transducer 18. The method of the embodiment can be applied an electronic device 500 and a vehicle that include the circuit device 20. The configuration of the physical quantity measurement device and the electronic device 500 is as described above with reference to Fig. 4.

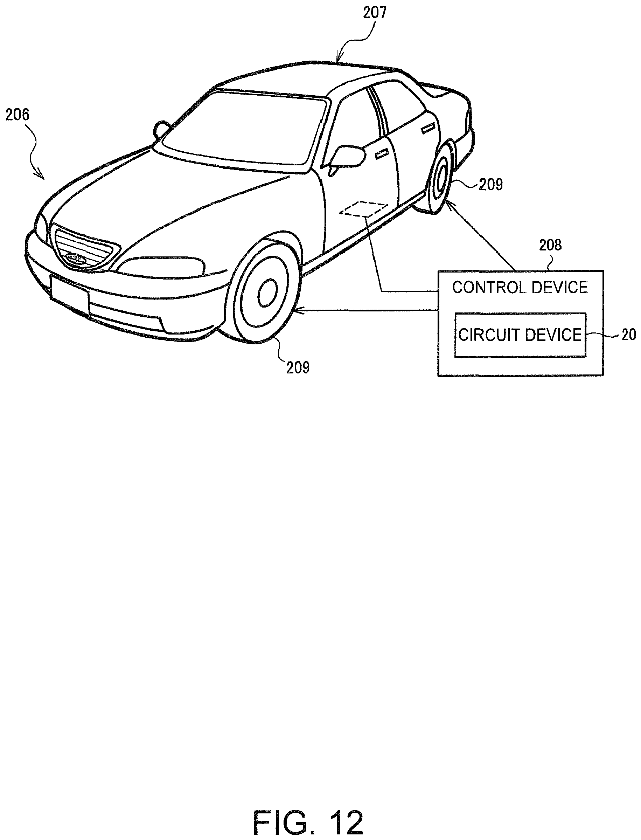

Fig. 12 illustrates an example of the vehicle including the circuit device 20 of the embodiment. The circuit device 20 of the embodiment can be incorporated in various vehicles such as an automobile, an airplane, a motorcycle, a bicycle, a ship, or the like. The vehicle is equipment or an apparatus that includes a driving mechanism such as an engine and a motor, a steering mechanism such as a steering wheel and a rudder, and various kinds of electronic equipment and moves on the ground, the sky, or the sea. Fig. 12 schematically illustrates an automobile 206 as a specific example of the vehicle. In an automobile 206, the gyro sensor 510 (sensor) including the vibrator element 10 and the circuit device 20 is incorporated. The gyro sensor 510 can measure posture of an automobile body 207. A measurement signal of the gyro sensor 510 can be supplied to a control device 208 (automobile body posture control device). The control device 208 can control hardness of the suspension according to the posture of the automobile body 207 or control brakes of the individual wheels 209, for example. In addition, such posture control can be used in various vehicles such as bipedal walking robots, aircrafts, helicopters, and the like. The gyro sensor 510 can be incorporated in realizing posture control.

Although the embodiment has been described in detail as above, it will be easily understood by a person skilled in the art that many modifications not deviating practically from the novel matters and effects of the invention are possible. Accordingly, all such modifications are regarded as being included in the scope of the invention. For example, terms (gyro sensor, vibrator element, and the like) described at least once in the specification or drawings together with terms in a broader sense or equivalent different terms (physical quantity measurement device, physical quantity transducer, and the like) can be replaced with the equivalent different term at any point in the specification or drawings. The configuration of the circuit device, the physical quantity measurement device, the electronic device, and the vehicle, the structure of the vibrator element, and the like are not limited to those described in the embodiment, and various modifications can be made thereto.

**Claims**

1. A circuit device comprising:

   a drive circuit configured to drive a physical quantity transducer by a drive signal;
   a PLL circuit configured to generate a clock signal by a phase locked loop (PLL) operation using the drive signal as a reference signal; and
   a measurement circuit that includes a circuit which is operated by an operation signal based on the clock signal and performs measurement processing based on a measurement signal from the physical quantity transducer, wherein a frequency of the drive signal is set as fdr, a frequency of the clock signal is set as fck, i is set as an integer of 1 or more, j is set as an integer of 1 or
   more, and a frequency of the operation signal is set as fck/i, the PLL circuit is configured to generate the clock signal having a frequency of $j \times fdr \neq fck/i$.

2. The circuit device according to Claim 1,
   wherein the PLL circuit is a fractional PLL circuit.

3. The circuit device according to Claim 1,
   wherein the PLL circuit includes
   a frequency division circuit for frequency-dividing the clock signal, and
   a phase comparator to which a frequency-divided clock signal from the frequency division circuit and the drive signal are input, and
   a frequency division ratio of the frequency division circuit is a non-integer.

4. The circuit device according to Claim 1,
   wherein the PLL circuit includes
   a first frequency division circuit for frequency-dividing the clock signal,
   a second frequency division circuit for frequency-dividing the drive signal, and
   a phase comparator to which a first frequency-divided clock signal from the first frequency division circuit and a second frequency-divided clock signal from the second frequency division circuit are input, and
   in a case where it is set that the frequency division ratio of the first frequency division circuit is N and the frequency division ratio of the second frequency division circuit is M, N/M is a non-integer.

5. The circuit device according to Claim 1,
   wherein the measurement circuit is configured to perform a measurement operation with a signal based on the drive signal.

6. The circuit device according to Claim 1,
   wherein the circuit which is operated by the operation signal includes at least one of an A/D conversion circuit, a digital signal processing circuit, and an interface unit.

7. The circuit device according to Claim 1,
   wherein the PLL circuit includes a voltage-controlled oscillator (VCO), and
   the VCO is any one of a CR oscillation circuit, an LC oscillation circuit, and a ring oscillator.

8. A physical quantity measurement device comprising:

   a circuit device according to any one of Claims 1 to 5; and
   a physical quantity transducer.

9. An electronic device comprising:

   a circuit device according to any one of Claims 1 to 4.

10. A vehicle comprising:

a circuit device according to any one of Claims 1 to 4.

FIG. 1

MEASURED VALUE VARIATION

$j \times fdr = fck/i$

fin1

fin2

fin3

fck1        fck2

FREQUENCY OF CLOCK SIGNAL

SETTING OF FREQUENCY
$j \times fdr \neq fck/i$

# FIG. 2

MEASURED VALUE VARIATION

$j \times fdr = k \times fck/i$

fin1

fin2

fin3

fin4

fin5

fin6

fin7

fin8

fck3

FREQUENCY OF CLOCK SIGNAL

SETTING OF FREQUENCY
$j \times fdr \neq k \times fck/i$

# FIG. 3

FIG. 4

EP 3 385 669 A1

FIG. 5

FIG. 6

FIG. 7

EP 3 385 669 A1

EP 3 385 669 A1

FIG. 8

EP 3 385 669 A1

fdr

156
SECOND FREQUENCY
DIVISION CIRCUIT (1/M)

157
TDC
(PHASE COMPARATOR)

158
DIGITAL
LOOP FILTER

159
DCO

fck

160
FIRST FREQUENCY DIVISION CIRCUIT
$(1/N' \Leftrightarrow 1/(N'+1))$

# FIG. 9

MOD TIMES

FRC TIMES

| N'<br>FREQUENCY-<br>DIVISION | ...... | N'<br>FREQUENCY-<br>DIVISION | N' + 1<br>FREQUENCY-<br>DIVISION | ...... | N' + 1<br>FREQUENCY-<br>DIVISION |

# FIG. 10

# FIG. 11

207

206

209

208

CONTROL DEVICE

CIRCUIT DEVICE — 20

209

# FIG. 12

Europäisches
Patentamt

European
Patent Office

Office européen
des brevets

# EUROPEAN SEARCH REPORT

Application Number

EP 18 16 3590

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/377625 A1 (AALTONEN LASSE [FI]) 31 December 2015 (2015-12-31) | 1,2,5-10 | INV. G01C19/5776 |
| A | * paragraphs [0004], [0046], [0047]; figures 1, 5 * | 3,4 | |
| X,D | JP 2016 133469 A (SEIKO EPSON CORP) 25 July 2016 (2016-07-25) * claim 1; figure 1 * | 1,5-10 | |

-----

-----

TECHNICAL FIELDS
SEARCHED      (IPC)

G01C
G01P

The present search report has been drawn up for all claims

| Place of search | Date of completion of the search | Examiner |
|---|---|---|
| The Hague | 31 August 2018 | Kuhn, Robert |

EPO FORM 1503 03.82 (P04C01)

## ANNEX TO THE EUROPEAN SEARCH REPORT
## ON EUROPEAN PATENT APPLICATION NO.

EP 18 16 3590

This annex lists the patent family members relating to the patent documents cited in the above-mentioned European search report.
The members are as contained in the European Patent Office EDP file on
The European Patent Office is in no way liable for these particulars which are merely given for the purpose of information.

31-08-2018

| Patent document cited in search report | Publication date | Patent family member(s) | Publication date |
|---|---|---|---|
| US 2015377625 A1 | 31-12-2015 | EP 3161417 A1<br>FI 127063 B<br>TW 201606265 A<br>US 2015377625 A1<br>WO 2016001801 A1 | 03-05-2017<br>31-10-2017<br>16-02-2016<br>31-12-2015<br>07-01-2016 |
| JP 2016133469 A | 25-07-2016 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016133469 A